# FASCICULE DE BREVET EUROPEEN

(11) **EP 2 752 878 B1**
(45) Date de publication et mention de la délivrance du brevet: **06.09.2017**
(21) Numéro de dépôt: 13199817.1
(22) Date de dépôt: 30.12.2013
(51) Int. Cl.: H01L 27/146

(54) **Capteur d'image**
Bilderfassungssensor
Image sensor

(30) Priorité: 02.01.2013 FR 1350008
(43) Date de publication de la demande: 09.07.2014
(73) Titulaire: COMMISSARIAT À L'ÉNERGIE ATOMIQUE ET AUX ÉNERGIES ALTERNATIVES, 75015 Paris (FR); STmicroelectronics SA, 92120 Montrouge (FR)
(72) Inventeur: Roy, François, 38180 SEYSSINS (FR); Cazaux, Yvon, 38100 GRENOBLE (FR)
(74) Mandataire: Thibon, Laurent

(56) Documents cités:
- EP-A1- 2 315 251
- US-A1- 2009 266 973
- US-A1- 2011 019 038
- US-A1- 2012 018 618
- US-A1- 2012 161 213

## Description

### Domaine

La présente description concerne un capteur d'image comportant une pluralité de pixels formés dans et sur un substrat semiconducteur. On s'intéresse ici plus particulièrement à un capteur adapté à un mode de commande dit à obturation globale ("global shutter" en anglais), c'est-à-dire dans lequel tous les pixels du capteur sont exposés simultanément.

### Exposé de l'art antérieur

Des structures de pixel compatibles avec une commande à obturation globale ont été proposées, par exemple dans les demandes de brevet US 2011/0019038 et US 2012/0161213. Ces structures présentent toutefois toutes leurs inconvénients propres.

Par ailleurs, un exemple de capteur d'image à grille de transfert verticale est décrit dans la demande de brevet EP2315251.

### Résumé

Ainsi, un mode de réalisation prévoit un capteur d'image selon la revendication 1. Selon un mode de réalisation : le substrat est dopé d'un premier type de conductivité ; la zone photosensible et la zone de stockage sont dopées d'un second type de conductivité ; et une couche dopée du premier type de conductivité, présentant un niveau de dopage supérieur à celui du substrat, recouvre la surface des zones photosensibles et de stockage.

Selon un mode de réalisation, la zone photosensible est partiellement délimitée par au moins une troisième électrode verticale isolée s'étendant dans le substrat.

Selon un mode de réalisation, le capteur comporte en outre une zone d'évacuation de charges juxtaposée à la zone photosensible.

Selon un mode de réalisation, au moins une quatrième électrode verticale isolée s'étend dans le substrat entre la zone photosensible et la zone d'évacuation de charges.

Selon un mode de réalisation, la quatrième électrode comprend au moins une ouverture définissant une zone de transfert de charges entre la zone photosensible et la zone d'évacuation de charges.

Selon un mode de réalisation, la zone d'évacuation de charges est reliée à un rail d'alimentation haut du capteur.

Selon un mode de réalisation, le capteur comporte en outre un circuit de commande adapté à appliquer des signaux de commande sur les électrodes verticales.

Selon un mode de réalisation, la zone de lecture est couplée à un circuit de lecture du capteur.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est une vue en coupe partielle simplifiée d'un exemple d'un pixel d'un capteur d'image ;
les figures 2 et 3A à 3G illustrent un mode de réalisation d'un pixel d'un capteur d'image ;
la figure 4 est une vue de dessus d'une variante de réalisation du pixel des figures 2 et 3A à 3G ; et
la figure 5 est un chronogramme illustrant un exemple d'un mode de commande du pixel de la figure 4.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

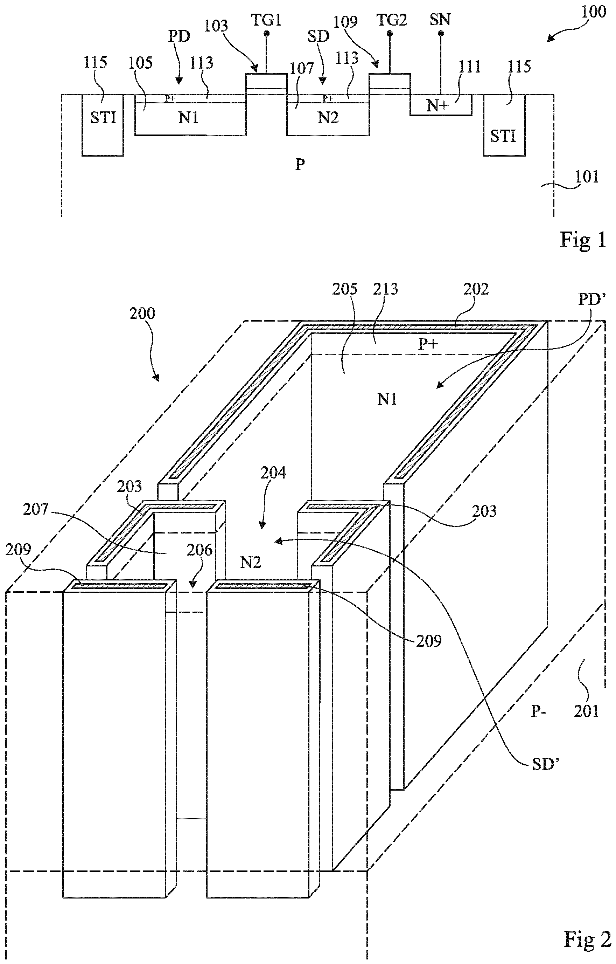

La figure 1 est une vue en coupe partielle simplifiée d'un exemple d'un pixel 100 d'un capteur d'image réalisé dans et sur un substrat semiconducteur 101. Dans cet exemple, le substrat 101 est faiblement dopé de type P (P-). Le pixel 100 comprend une structure de grille isolée 103 formée sur le substrat 101. De part et d'autre de la grille 103, se trouvent, en surface du substrat 101, des régions 105 et 107 dopées de type N. La région 105 (à gauche de la grille 103 sur la figure) forme avec le substrat 101 la jonction d'une photodiode PD. La région 107 (à droite de la grille 103) forme avec le substrat 101 la jonction d'une diode SD définissant une zone intermédiaire de stockage de charges du pixel. Dans cet exemple, la région 107 a, vu de dessus, une surface moins importante que la région 105, et a un niveau de dopage (N2) supérieur à celui (N1) de la région 107. Les diodes PD et SD comportent en outre, en surface des régions 105 et 107, une région 113 peu profonde fortement dopée de type P (P+) . La photodiode PD et la diode SD sont appelées diodes déplétées ou diodes pincées ("pinned diode" en anglais), dans la mesure où le potentiel des régions 105 et 107 est, en l'absence d'éclairement et après transfert des charges, fixé uniquement par les concentrations de dopants des régions 101, 105, 107 et 113. Le pixel 100 comprend en outre, à côté de la région 107 et à l'opposé de la grille 103 (à droite de la région 107 sur la figure), une deuxième structure de grille isolée 109 formée sur le substrat 101, parallèle à la structure 103. A côté de la grille 109 et à l'opposé de la région 107 (à droite de la grille 109 sur la figure), on trouve une région 111 fortement dopée de type N (N+) formée en surface du substrat 101, définissant une zone de lecture du pixel. La région 111 est plus fortement dopée et de plus petite surface (vu de dessus) que la région 107. Les grilles 103 et 109 et la région 111 sont reliées par des métallisations (non représentées), respectivement à des noeuds TG1 et TG2 d'application de signaux de commande, et à un noeud SN relié à un circuit de lecture de tension. La structure de la figure 1 comprend également une tranchée isolante 115 formée autour du pixel 100, qui permet de limiter les interférences, encore appelées diaphotie ("crosstalk" en anglais), entre les différentes photodiodes, c'est-à-dire la capture, par une photodiode, d'électrons destinés à atteindre une photodiode voisine. La tranchée 115 peut être une tranchée de type STI (de l'anglais "Shallow Trench Isolation"), c'est-à-dire une tranchée peu profonde remplie d'oxyde de silicium.

Lorsque le capteur est éclairé, des photons pénètrent dans le substrat et y forment des paires électrons/trous. Les électrons sont ensuite attirés dans la région d'accumulation 105. Lorsqu'un potentiel adapté est appliqué sur la grille 103, un canal se forme en surface du substrat 101 sous la grille 103, et les électrons accumulés dans la région 105 sont amenés vers la région de stockage 107. Lorsqu'un potentiel adapté est appliqué sur la grille 109, un canal se forme en surface du substrat 101 sous la grille 109, et les électrons stockés dans la région 107 sont amenés vers la région de lecture 111, puis vers le circuit de lecture (non représenté) par l'intermédiaire du noeud SN.

La structure de pixel de la figure 1 est compatible avec des modes de commande à obturation globale. A titre d'exemple de mode de commande à obturation globale, on peut prévoir d'appliquer aux grilles 103 de tous les pixels du capteur, un même signal impulsionnel TG1, par exemple périodique, adapté à commander de façon simultanée, dans tous les pixels du capteur, le transfert des charges accumulées dans la photodiode PD du pixel, vers la diode intermédiaire de stockage SD du pixel. La fin d'une impulsion du signal TG1 marque la fin d'une période d'intégration du capteur, et le début de la période d'intégration suivante. Pendant l'intégration, dans chaque pixel, une quantité d'électrons fonction de l'intensité lumineuse reçue par le pixel s'accumule dans la photodiode PD. Pendant l'impulsion de transfert du signal TG1, les électrons photogénérés contenus dans la photodiode sont transférés dans la diode de stockage SD du pixel, ce qui réinitialise la photodiode PD à son potentiel propre de repos, fixé par les niveaux de dopage. Les diodes intermédiaires de stockage SD permettent ainsi de mémoriser temporairement, sous forme analogique, l'image acquise par les photodiodes PD pendant l'intégration. Avant la fin de la période d'intégration suivante, on peut prévoir de parcourir tous les pixels du capteur, et, dans chaque pixel, de transférer les charges contenues dans la diode SD du pixel vers la région de lecture 111 du pixel (ce qui réinitialise la diode SD), puis de lire le potentiel du noeud de lecture SN connecté à la région 111. Plus spécifiquement, avant la fin de la nouvelle période d'intégration, on peut prévoir de mettre en oeuvre, dans chaque pixel, les étapes successives suivantes : a) réinitialiser le noeud de lecture SN à un potentiel de référence ; b) lire le potentiel du noeud SN ; c) appliquer sur la grille 109 un signal TG2 adapté à commander le transfert des charges stockées dans la diode SD vers la région 111 ; et d) lire à nouveau le potentiel du noeud SN. La différence de valeur de potentiel sur le noeud SN entre la première et la deuxième étape de lecture est représentative de la quantité de charges transférée depuis la diode SD, et donc de l'intensité lumineuse reçue par la photodiode PD du pixel pendant la période d'intégration précédente. Cette différence peut être numérisée et mémorisée en vue de générer une image numérique. Lorsque les pixels du capteur sont agencés en réseau matriciel, le capteur peut par exemple être parcouru ligne par ligne, et les étapes successives a) à d) peuvent être mises en oeuvre simultanément dans tous les pixels de la ligne sélectionnée.

La structure de pixel de la figure 1 présente de bonnes performances dans les applications à commande à obturation globale, notamment grâce à la prévision de la zone de stockage intermédiaire formée par la diode SD, qui permet de limiter de façon significative les phénomènes de distorsion d'image liés au bruit temporel du transistor (non représenté) commandant la réinitialisation des zones de lecture 111 (aussi appelé bruit en kTc). Cette structure peut toutefois être améliorée.

Pour une capacité donnée de stockage de charges dans la photodiode PD et dans la diode de stockage SD, il serait souhaitable de réduire la surface de substrat occupée par le pixel 100. Pour cela, on pourrait diminuer la taille des diodes PD et SD en surface sur le substrat 101, et augmenter l'épaisseur des régions d'accumulation 105 et 107 pour conserver un volume d'accumulation d'électrons constant. Toutefois, les canaux permettant les transferts de charge de la région 105 à la région 107 et de la région 107 à la région 111 étant formés en surface du substrat 101, une augmentation d'épaisseur des régions d'accumulation 105 et 107 au-delà de 0,5 à 1 µm rendrait difficile voire impossible le transfert de la totalité des charges de la région 105 à la région 107, et/ou de la région 107 à la région 111. Des transferts incomplets pourraient se produire, entraînant notamment des phénomènes de rémanence indésirables. En outre, augmenter l'épaisseur des régions d'accumulation 105 et 107 aurait pour effet d'amplifier la profondeur des puits de potentiel contenant les charges photogénérées, et il serait alors nécessaire d'appliquer une tension de transfert plus importante sur les grilles 103 et 109. Une autre possibilité serait de diminuer la taille des diodes PD et SD en surface sur le substrat 101 sans augmenter l'épaisseur des régions 105 et 107, mais en augmentant leurs niveaux de dopage. Toutefois, il serait alors nécessaire d'appliquer une tension de transfert plus importante sur les grilles 103 et 109.

De plus, dans la structure de la figure 1, les puits de potentiel contenant les charges photogénérées sont fixés uniquement par les niveaux de dopage. Le puits de potentiel de la diode de stockage SD devant être plus profond que celui de la photodiode PD pour assurer le transfert des charges de la photodiode PD vers la diode SD sans risque de retour en arrière, ceci implique que les niveaux de dopage des diodes SD et PD doivent être différents.

En outre, la tranchée 115 d'isolement du pixel limite, mais n'annule pas complètement la diaphotie. En effet, la tranchée 115 peut typiquement avoir une profondeur de l'ordre de 0,3 à 1 µm, alors que des charges peuvent être photogénérées jusqu'à une profondeur de l'ordre de 3 à 10 µm dans le substrat (en fonction de la longueur d'onde du faisceau incident). Des charges photogénérées peuvent donc passer sous la tranchée 115 et être capturées par une photodiode différente de celle à laquelle elles étaient destinées.

Un objet d'un mode de réalisation est d'améliorer la structure décrite en relation avec la figure 1.

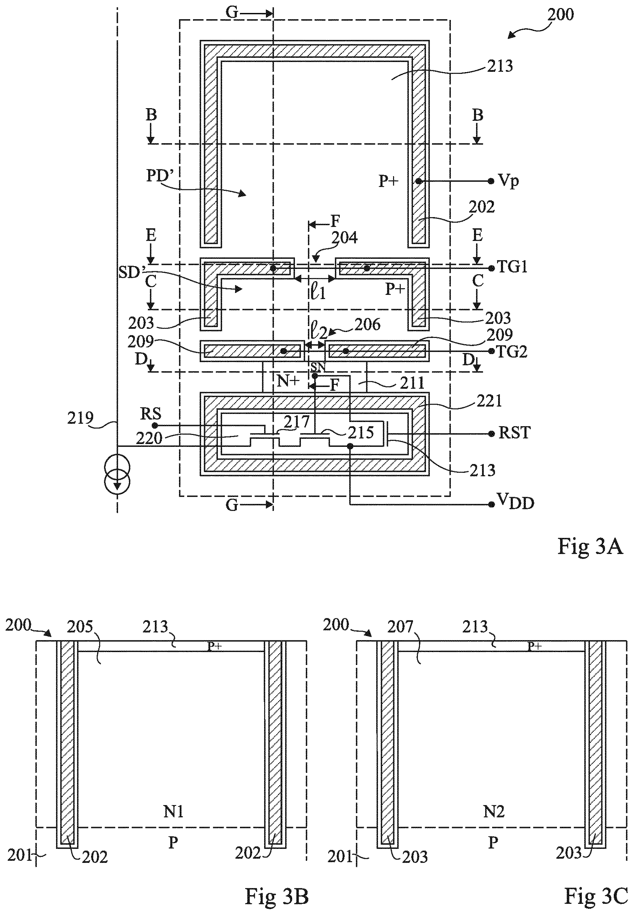

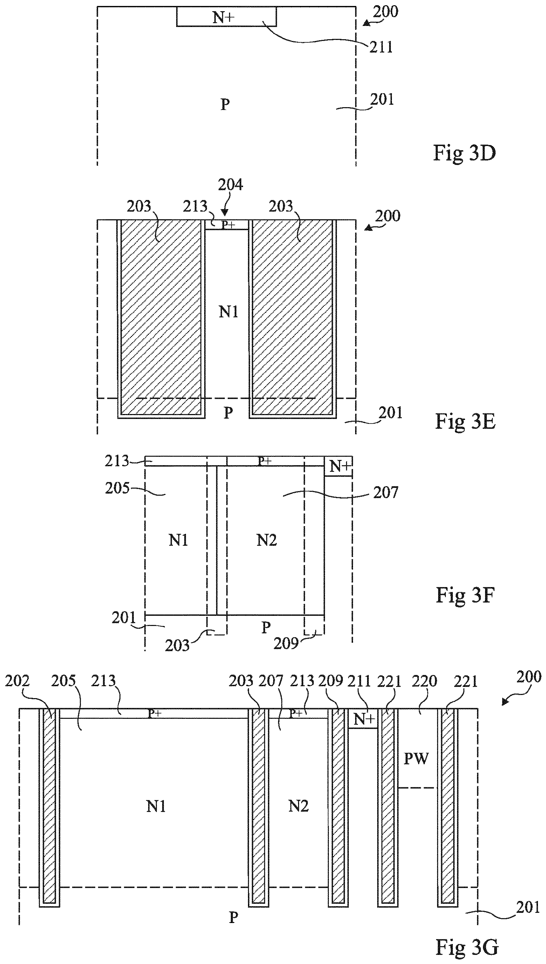

Les figures 2 et 3A à 3G illustrent un exemple d'un mode de réalisation d'un pixel 200 d'un capteur d'image réalisé dans et sur un substrat semiconducteur 201, par exemple en silicium. La figure 2 est une vue en perspective partielle du pixel 200. La figure 3A représente ce pixel vu de dessus. Les figures 3B à 3G sont des vues en coupe de côté respectivement selon les plans B-B, C-C, D-D, E-E, F-F et G-G de la figure 3A.

Le pixel 200 comprend une zone photosensible, une zone intermédiaire de stockage de charges, une zone de lecture connectée à un circuit de lecture et de traitement, et un dispositif de transfert de charges de la zone photosensible vers la zone de stockage, et de la zone de stockage vers la zone de lecture. Pour des raisons de clarté, la zone de lecture et le circuit de lecture et de traitement n'ont pas été représentés sur la vue en perspective de la figure 2.

Dans cet exemple, le substrat 201 est faiblement dopé de type P (P-). La zone photosensible du pixel 200 comprend un caisson 205 dopé de type N, de niveau de dopage N1, formant avec le substrat 201 la jonction d'une photodiode PD'. La zone intermédiaire de stockage du pixel comprend, juxtaposé au caisson 205, un caisson 207 dopé de type N, de niveau de dopage N2, formant avec le substrat 201 la jonction d'une diode SD'. Les caissons 205 et 207 sont formés en partie supérieure du substrat 201. Dans cet exemple, les caissons 205 et 207 ont la même profondeur. Les caissons 205 et 207 sont par exemple approximativement parallélépipédiques avec un côté commun. Dans cet exemple, le caisson 205 a, vu de dessus, une surface supérieure à celle du caisson 207, et son niveau de dopage (N1) est inférieur à celui (N2) du caisson 207, de sorte que les diodes PD' et SD' ont des capacités de stockage de charges similaires ou égales. Une mince couche 213 fortement dopée de type P (P+) peut être formée en surface des caissons 205 et 207. La photodiode PD' et la diode SD' sont des diodes de type déplétées ou diodes pincées. La zone de lecture du pixel 200 comprend, juxtaposée au caisson 207, du côté du caisson 207 opposé au caisson 205 dans cet exemple, une région 211 fortement dopée de type N (N+). La région 211 est plus fortement dopée que les caissons 205 et 207, et est formée en surface du substrat 201 sur une épaisseur inférieure à celle des caissons. A titre d'exemple, les caissons 205 et 207 peuvent avoir une épaisseur comprise entre 1 et 10 µm, et de préférence entre 2 et 4 µm, et la région de lecture 211 peut avoir une épaisseur comprise entre 0,1 et 0,5 µm.

Une électrode ou grille verticale isolée 203 s'étend dans le substrat entre les caissons 205 et 207, au niveau de leur côté commun. L'électrode 203 s'étend de préférence jusqu'à une profondeur au moins égale à celle des caissons 205 et 207. L'électrode 203 isole le caisson 205 du caisson 207, sauf en une zone 204 de transfert de charges, dans laquelle l'électrode 203 comprend une ouverture reliant le caisson 205 au caisson 207. La zone 204 s'étend de préférence sur toute la hauteur des caissons 205 et 207. Dans l'exemple représenté, l'électrode 203 s'étend jusqu'à une profondeur légèrement supérieure à celle des caissons, et a, vu de dessus, la forme d'un U délimitant l'essentiel de trois côtés du caisson 207, la barre horizontale du U étant située en regard du côté commun aux caissons 205 et 207. Le pan d'électrode 203 situé entre les caissons 205 et 207 (correspondant à la barre horizontale du U en vue de dessus) comprend une ouverture en forme de bande verticale de largeur 11, qui s'étend sur toute la hauteur de l'électrode et définit la zone de transfert 204.

Une autre électrode ou grille verticale isolée 209 s'étend dans le substrat entre le caisson 207 et la région de lecture 211, au niveau de leur côté commun. L'électrode 209 s'étend de préférence jusqu'à une profondeur au moins égale à celle du caisson 207. L'électrode 209 isole le caisson 207 de la région 211, sauf en une zone 206 de transfert de charges, dans laquelle l'électrode 209 comprend une ouverture reliant le caisson 207 à la région 211, cette ouverture s'étendant de préférence sur toute la hauteur du caisson 207. Dans l'exemple représenté, l'électrode 209 s'étend sur une profondeur légèrement supérieure à celle du caisson 207, et a la forme d'un pan vertical délimitant l'essentiel du côté du caisson 207 juxtaposé à la région 211 (c'est-à-dire le côté du caisson 207 opposé à la zone de transfert 204), et comporte une ouverture en forme de bande verticale de largeur 12, qui s'étend sur toute la hauteur de l'électrode et définit la zone de transfert 206.

Dans cet exemple, une autre électrode ou grille verticale isolée 202 délimite latéralement l'essentiel des trois côtés du caisson 205 non délimités par l'électrode 203. L'électrode 202 s'étend de préférence jusqu'à une profondeur au moins égale à celle du caisson 205.

Pour former les électrodes 202, 203 et 209, on peut par exemple former, autour des caissons 205 et 207, des tranchées s'étendant verticalement dans le substrat depuis sa face avant, selon un motif correspondant à la forme souhaitée des électrodes. Les parois latérales et le fond des tranchées peuvent être revêtus d'un matériau isolant comprenant par exemple de l'oxyde de silicium, puis les tranchées peuvent être remplies d'un matériau conducteur. A titre d'exemple, le matériau conducteur de remplissage des tranchées est du silicium polycristallin fortement dopé, par exemple de niveau de dopage compris entre 1x10¹⁸ atomes/cm³ et 1x10²⁰ atomes/cm³. A titre de variante, le matériau conducteur de remplissage des tranchées est un métal, par exemple un métal du groupe comprenant le cuivre et le tungstène. A titre d'exemple, les tranchées peuvent avoir une profondeur comprise entre 1 et 10 µm, et de préférence entre 2 et 5 µm, et une largeur comprise entre 0,1 et 0,5 µm.

Les faces supérieures des électrodes 202, 203 et 209 et de la région 211 sont reliées par des métallisations (non représentées), respectivement à un noeud Vp d'application d'un signal de polarisation, à des noeuds TG1 et TG2 d'application de signaux de commande en transfert de charges, et à un noeud SN relié ou couplé à un circuit de lecture de tension.

Dans l'exemple représenté, le circuit de lecture (figure 3A) comprend un transistor 213 reliant le noeud SN à un rail d'alimentation haute V_{DD} du capteur, un transistor 215 monté en source suiveuse, dont la grille est reliée au noeud SN et dont le drain est relié au rail V_{DD}, et un transistor 217 reliant la source du transistor 215 à une ligne de lecture 219 d'un réseau matriciel comportant le pixel 200. La grille du transistor 213 est reliée à un noeud RST d'application d'un signal de commande en réinitialisation de la région 211, et la grille du transistor 217 est reliée à un noeud RS d'application d'un signal de sélection du pixel 200. Dans cet exemple, les transistors 213, 215 et 217 sont formés dans un caisson 220 dopé de type P (PW), délimité latéralement par une région d'isolement 221. Dans cet exemple, la région d'isolement 221 comprend une tranchée à parois isolées remplie d'un matériau conducteur entourant le caisson 220, cette tranchée pouvant être formée en même temps que les électrodes verticales 202, 203 et 209. A titre de variante, la région d'isolement 221 peut être remplacée par tout autre dispositif connu d'isolation périphérique d'un caisson comportant des transistors, par exemple une tranchée de type STI ou une isolation par jonction.

Un exemple d'un mode d'utilisation ou de commande du pixel 200 des figures 2 et 3A à 3G va maintenant être décrit.

En phase d'accumulation de charges ou d'intégration, les signaux Vp et TG1 sont fixés à un potentiel de référence. A titre d'exemple, ce potentiel pourra être celui de la masse, ou être négatif par rapport à la masse, par exemple de l'ordre de -1 V. Une telle polarisation des électrodes 202 et 203 entraîne une accumulation de trous le long des parois des tranchées verticales délimitant la zone photosensible. Des trous s'accumulent également dans la zone de transfert 204, bloquant les échanges d'électrons entre les caissons 205 et 207. Le substrat 201 étant lui aussi polarisé à un potentiel de référence, par exemple celui de la masse, il se forme un puits de potentiel dans le caisson 205, qui, en l'absence d'éclairement, dépend des niveaux de dopage et des potentiels de polarisation des électrodes et du substrat. Lorsque la photodiode PD' est éclairée, des paires électrons/trous sont photogénérées dans la photodiode, et les électrons photogénérés sont attirés et piégés dans le caisson 205.

En phase de transfert des charges photogénérées accumulées dans la photodiode PD' vers la diode intermédiaire de stockage SD', le signal Vp reste inchangé, c'est-à-dire que l'électrode 202 reste polarisée au même potentiel de référence que pendant la phase d'accumulation. Ce même potentiel de référence est également appliqué au signal TG2, ce qui entraîne l'accumulation de trous dans la zone de transfert 206, bloquant les échanges d'électrons entre le caisson 207 et la région 211. Le signal TG1 est fixé à une valeur supérieure au potentiel maximal du puits de potentiel formé dans la photodiode PD' pendant l'intégration, par exemple à une valeur comprise entre 2 et 3 V. Ceci entraîne le transfert de tous les électrons photogénérés contenus dans le caisson 205 vers le caisson 207, via la zone de transfert 204. Une fois le transfert effectué, le signal TG1 est à nouveau mis à la même valeur basse que les signaux Vp et TG2, de façon à créer, dans le caisson 207, un puits de potentiel adapté à maintenir les électrons transférés confinés dans le caisson 207, dans l'attente d'un transfert ultérieur vers la zone de lecture 211. A ce stade, la photodiode PD' est vide de toute charge photogénérée (c'est-à-dire dans un état réinitialisé), et une nouvelle phase d'intégration peut commencer.

En phase de transfert des charges contenues dans la diode intermédiaire SD' vers la zone de lecture 211, les signaux Vp et TG1 sont maintenus au même potentiel de référence de valeur basse que pendant la phase d'intégration. Le signal TG2 est fixé à une valeur supérieure au potentiel maximal du puits de potentiel formé dans la diode SD' pendant la phase de stockage intermédiaire, par exemple à une valeur comprise entre 2 et 3 V. Ceci entraîne le transfert de tous les électrons photogénérés contenus dans le caisson 207 vers la région 211, via la zone de transfert 206. Une fois le transfert effectué, le signal TG2 est à nouveau mis à la même valeur basse que les signaux Vp et TG1, de façon à bloquer les échanges d'électrons entre le caisson 207 et la région 211. A ce stade, la diode SD' est vide de toute charge photogénérée (c'est-à-dire dans un état réinitialisé).

On notera que dans l'exemple représenté, la largeur 11 de la zone de transfert 204 est supérieure à la largeur 12 de la zone de transfert 206. Ceci permet, bien que les zones 204 et 206 n'aient pas le même niveau de dopage, d'utiliser des signaux TG1 et TG2 de niveaux haut et bas similaires, pour commander respectivement la mise en conduction et le blocage des zones 204 et 206. A titre de variante, on pourrait prévoir des zones de transfert 204 et 206 de même largeur et utiliser des signaux TG1 et TG2 de niveaux distincts.

La structure de pixel des figures 2 et 3A à 3G est compatible avec une commande à obturation globale, par exemple une commande du type décrit ci-dessus en relation avec la figure 1. Cette structure permet notamment, grâce à la prévision de la zone intermédiaire de stockage SD', d'éviter des phénomènes de distorsion liés au bruit de réinitialisation des zones de lecture 211 du capteur (bruit kTc).

Un avantage de la structure des figures 2 et 3A à 3G est que, pour une capacité donnée de stockage de charges dans la zone photosensible et dans la zone intermédiaire de stockage, elle permet de réduire considérablement la surface de substrat occupée (vu de dessus) par le pixel par rapport aux structures du type décrit en relation avec la figure 1, utilisant des grilles de transfert horizontales formées sur la surface du substrat. En effet, dans la structure des figures 2 et 3A à 3G, l'utilisation de grilles et de zones de transfert verticales permet d'augmenter de façon significative l'épaisseur des couches d'accumulation de type N de la photodiode et de la diode de stockage, tout en garantissant des transferts de charges complets entre les différentes zones du pixel, et en évitant ainsi des phénomènes indésirables de rémanence. On peut donc réduire la surface occupée, vu de dessus, par le pixel.

Un autre avantage est que la polarisation des électrodes verticales à un potentiel de référence pendant les phases d'intégration et de stockage intermédiaire, qui forme une accumulation de trous autour de ces électrodes, permet d'éliminer des courants d'obscurité qui sont habituellement formés dans les capteurs d'image, à l'interface avec les zones d'isolement des pixels.

Un autre avantage de la structure des figures 2 et 3A à 3G est que les électrodes verticales isolées forment, entre des pixels voisins, des séparations profondes permettant de limiter fortement la diaphotie.

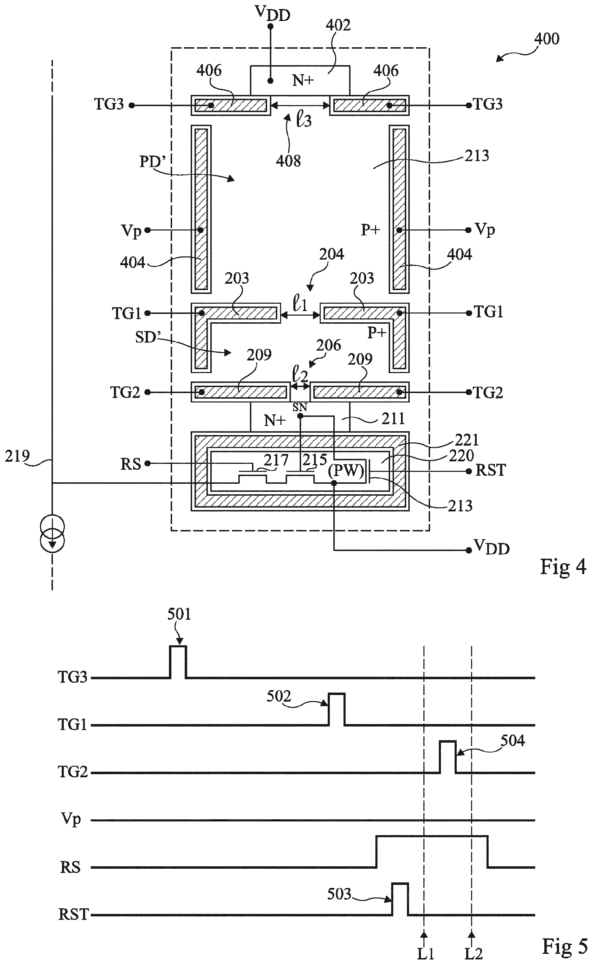

La figure 4 est une vue de dessus illustrant une variante de réalisation du pixel des figures 2 et 3A à 3G. Le pixel 400 de la figure 4 comprend de nombreux éléments communs avec le pixel 200 des figures 2 et 3A à 3G. Seules les différences entre les deux structures seront décrites ici. Le pixel 400 diffère du pixel 200 essentiellement en ce qu'il comprend, en plus du pixel 200, un dispositif anti-éblouissement ("anti-blooming" en anglais) permettant d'éviter que, en cas de saturation de la photodiode PD' pendant une période d'intégration, un surplus de charges photogénérées ne se déverse dans la zone intermédiaire de stockage SD', entrainant une pollution de l'image acquise pendant la période d'intégration précédente.

Le dispositif anti-éblouissement du pixel 400 comprend, juxtaposée au caisson 205, une région 402 fortement dopée de type N (N+). Dans cet exemple, la région 402 est située du côté du caisson 205 opposé au caisson 207. Plus généralement, la région 402 peut être située du côté de l'un quelconque des bords libres (c'est-à-dire non juxtaposé au caisson 207) du caisson 205. La région 402 est formée en surface du substrat 201 sur une épaisseur inférieure à celle des caissons 205 et 207. La région 402 est par exemple formée en même temps que la région de lecture 211 du pixel.

L'électrode verticale 202 du pixel 200, délimitant les trois côtés de la photodiode PD' non délimités par l'électrode 203, est, dans le pixel 400, remplacée par deux électrodes ou grilles verticales isolées référencées respectivement 404 et 406. L'électrode 406 s'étend entre le caisson 205 et la région 402, au niveau de leur côté commun, de préférence jusqu'à une profondeur au moins égale à celle du caisson 205. L'électrode 406 isole le caisson 205 de la région 402, sauf en une zone 408 de transfert de charges, dans laquelle l'électrode 406 comprend une ouverture reliant le caisson 205 à la région 402, cette ouverture s'étendant de préférence sur toute la hauteur du caisson 205. Dans cet exemple, l'électrode 406 s'étend sur une profondeur légèrement supérieure à celle du caisson 205, et a la forme d'un pan vertical délimitant l'essentiel du côté du caisson 205 juxtaposé à la région 402, et comporte une ouverture en forme de bande verticale de largeur 13, qui s'étend sur toute la hauteur de l'électrode et définit la zone de transfert 408. L'électrode 404 comporte deux pans verticaux parallèles délimitant respectivement les deux côtés du caisson 205 non délimités par les électrodes 203 et 406. L'électrode 404 s'étend de préférence jusqu'à une profondeur au moins égale à celle du caisson 205.

Les faces supérieures des électrodes 404 et 406 et de la région 402 sont reliées par des métallisations (non représentées), respectivement à un noeud Vp d'application d'un signal de polarisation, à un noeud TG3 d'application d'un signal de commande en transfert de charges, et à un dispositif d'évacuation de charges, par exemple un rail d'alimentation haute V_{DD} du capteur.

La figure 5 est un chronogramme illustrant un exemple d'un mode de commande du pixel de la figure 4. Sur la figure 5, on a représenté l'évolution en fonction du temps des signaux TG3, TG1, TG2, Vp, RS et RST de commande du pixel 400, lors d'un cycle comportant une phase d'intégration de la photodiode PD', une phase de transfert des charges photogénérées de la photodiode PD' vers la diode intermédiaire SD', et une phase de lecture du niveau de charge de la diode intermédiaire SD'.

Avant le début d'une phase d'intégration, les signaux TG1 et Vp sont à un état bas, et une impulsion 501 est appliquée au signal TG3. Pendant l'impulsion 501, le signal TG3 est fixé à un potentiel adapté à provoquer le transfert de toutes les charges photogénérées contenues dans le caisson 205 vers la région 402 via la zone de transfert 408, par exemple un potentiel compris entre 2 et 3 V. Ceci revient à utiliser le dispositif anti-éblouissement pour réinitialiser la photodiode PD'. Une fois la réinitialisation effectuée, le signal TG3 est remis au même état bas que les signaux Vp et TG1, ce qui bloque les échanges d'électrons entre le caisson 205 et la région 402. Le front descendant de l'impulsion 501 marque le début de la période d'intégration.

A la fin de la période d'intégration, les signaux TG3 et Vp restent à l'état bas, et le signal TG2 est également mis à l'état bas pour bloquer les échanges d'électrons entre la diode intermédiaire SD' et la région de lecture 211. Une impulsion 502 est appliquée au signal TG1. Pendant l'impulsion 502, le signal TG1 est fixé à un potentiel adapté à provoquer le transfert de toutes les charges photogénérées contenues dans le caisson 205 vers le caisson 207 via la zone de transfert 204. Le front descendant de l'impulsion 502 marque la fin de la période d'intégration.

Après la fin de la période d'intégration et avant la fin d'une période d'intégration suivante (non représentée), lors d'une phase de lecture du niveau de charge contenu dans le caisson 207, le transistor 217 du circuit de lecture (transistor de sélection du pixel 400) est rendu passant. Pour cela, le signal RS est, dans cet exemple, mis à un état haut. Une impulsion 503 est ensuite appliquée au signal RST, entraînant la réinitialisation de la région de lecture 211 au potentiel du rail V_{DD} (à la chute de tension du transistor 213 près). Après la fin de l'impulsion 503, le potentiel du noeud SN est lu lors d'une étape de lecture L1. Après l'étape de lecture L1, une impulsion 504 est appliquée au signal TG2. Pendant l'impulsion 504, le signal TG2 est fixé à un potentiel adapté à provoquer le transfert de toutes les charges photogénérées contenues dans le caisson 207 vers la région de lecture 211 via la zone de transfert 206. Après la fin de l'impulsion 504, le potentiel du noeud SN est à nouveau lu lors d'une étape de lecture L2. Le signal RS de sélection du pixel 400 peut alors être remis à un état bas en attendant un nouveau cycle d'intégration/transfert/lecture. La différence entre le potentiel lu sur le noeud SN à l'étape L1 et le potentiel lu sur le noeud SN à l'étape L2 peut être numérisée pour générer une valeur de sortie du pixel. Les étapes de lecture L1 et L2 sont de préférence très rapprochées dans le temps, pour minimiser les phénomènes de distorsion liés au bruit temporel du transistor de réinitialisation 213.

On notera que dans l'exemple représenté, la largeur 13 de la zone de transfert 408 est supérieure à la largeur 11 de la zone de transfert 204. Ceci permet d'obtenir l'effet anti-éblouissement recherché, c'est-à-dire que, pendant les phases d'intégration, en cas de saturation, le surplus de charges photogénérées qui ne peut pas être contenu dans la photodiode PD' s'écoule préférentiellement dans la région 402 plutôt que dans la région 207. A titre de variante, on peut prévoir de jouer sur les potentiels de polarisation des électrodes 203 et 406 pour obtenir l'effet anti-éblouissement recherché.

Des modes de réalisation particuliers ont été décrits. Diverses variantes et modifications apparaîtront à l'homme de l'art.

En particulier, les modes de réalisation décrits ne se limitent pas à l'exemple de circuit de lecture représenté aux figures 3A et 4. L'homme de l'art saura obtenir le fonctionnement recherché en utilisant d'autres circuits de lecture connus.

En outre, dans la structure décrite, certaines électrodes verticales isolées (notamment les électrodes 203 et 209 et l'électrode 406) comprennent chacune deux portions d'électrodes disjointes. Dans les exemples de modes de commande décrits, les portions disjointes d'une même électrode reçoivent un même signal de commande. A titre de variante, on peut prévoir de considérer ces portions d'électrode disjointes comme des électrodes distinctes, et leur appliquer des signaux de commande différents. A titre d'exemple, pour commander le transfert des charges d'une zone semiconductrice à une autre, on peut prévoir d'appliquer un signal positif sur une seule des deux portions de l'électrode 203, 209 ou 406 respectivement.

Plus généralement, les modes de réalisation décrits ne se limitent pas aux exemples particuliers de disposition et de configuration des électrodes verticales représentés aux figures 2, 3A à 3G et 4. Les avantages recherchés pourront être obtenus en prévoyant d'autres dispositions des électrodes verticales isolées, et/ou un nombre d'électrodes verticales isolées par pixel supérieur à ce qui a été représenté.

De plus, on a décrit ici des dispositifs de capture d'image dans lesquels la zone photosensible et la zone intermédiaire de stockage sont des diodes pincées. On comprendra que tout type d'élément photosensible et tout type d'élément de stockage pourront être délimités par les électrodes verticales décrites. Par exemple, on pourra considérer une photodiode et une diode intermédiaire de stockage exemptes de la zone 213 fortement dopée de type P.

Par ailleurs, les modes de réalisation décrits ne se limitent pas au cas où les caissons 205 et 207 d'accumulation des électrons sont de même profondeur.

## Revendications

1. Capteur d'image disposé dans et sur un substrat semiconducteur (201), ayant une pluralité de pixels (200 ; 400) comportant chacun :
une zone photosensible (205), une zone de lecture (211), et une zone de stockage (207) s'étendant entre la zone photosensible (205) et la zone de lecture (211);
au moins une première électrode verticale isolée (203) s'étendant dans le substrat entre la zone photosensible (205) et la zone de stockage (207), cette électrode comprenant une première ouverture en forme de bande verticale d'une première largeur (11) définissant une zone (204) de transfert de charges entre la zone photosensible (205) et la zone de stockage (207) ; et
au moins une deuxième électrode verticale isolée (209) s'étendant dans le substrat entre la zone de stockage (207) et la zone de lecture (211), cette électrode comprenant une deuxième ouverture en forme de bande verticale d'une deuxième largeur (12) définissant une zone (206) de transfert de charges entre la zone de stockage (207) et la zone de lecture (211),
characterisé en ce que
la zone photosensible (205) a un premier niveau de dopage (N1) et la zone de stockage (207) a un deuxième niveau de dopage (N2) supérieur au premier niveau (N1) et en ce que
la deuxième largeur (12) est inférieure à la première largeur (11).

2. Capteur selon la revendication 1, dans lequel :
le substrat (201) est dopé d'un premier type de conductivité ;
la zone photosensible (205) et la zone de stockage (207) sont dopées d'un second type de conductivité ; et
une couche (213) dopée du premier type de conductivité, présentant un niveau de dopage supérieur à celui du substrat, recouvre la surface des zones photosensibles (205) et de stockage (207).

3. Capteur selon la revendication 1 ou 2, dans lequel la zone photosensible (205) est partiellement délimitée par au moins une troisième électrode verticale isolée (202 ; 404) s'étendant dans le substrat.

4. Capteur selon l'une quelconque des revendications 1 à 3, comportant en outre une zone d'évacuation de charges (402) juxtaposée à la zone photosensible (205).

5. Capteur selon la revendication 4, dans lequel au moins une quatrième électrode verticale isolée (406) s'étend dans le substrat entre la zone photosensible (205) et la zone d'évacuation de charges (402).

6. Capteur selon la revendication 5, dans lequel ladite au moins une quatrième électrode (406) comprend au moins une ouverture définissant une zone (408) de transfert de charges entre la zone photosensible (205) et la zone d'évacuation de charges (402).

7. Capteur selon l'une quelconque des revendications 4 à 6, dans lequel ladite zone d'évacuation de charges (402) est reliée à un rail d'alimentation haut (V_{DD}) du capteur.

8. Capteur selon l'une quelconque des revendications 1 à 7, comportant en outre un circuit de commande adapté à appliquer des signaux de commande sur lesdites électrodes verticales (202, 203, 209 ; 404, 406).

9. Capteur selon l'une quelconque des revendications 1 à 7, dans lequel ladite zone de lecture (211) est couplée à un circuit de lecture du capteur.

## Patentansprüche

1. Ein Bildsensor, der in und auf einem Halbleitersubstrat (201) angeordnet ist mit einer Vielzahl von Pixeln (200; 400), wobei jedes Folgendes aufweist:
einen lichtempfindlichen Bereich (205), einen Lese-Bereich (211) und einen Speicher-Bereich (207), der sich zwischen dem lichtempfindlichen Bereich (205) und dem Lese-Bereich (211) erstreckt;
wenigstens eine erste isolierte vertikale Elektrode (203), die sich in dem Substrat zwischen dem lichtempfindlichen Bereich (205) und dem Speicher-Bereich (207) erstreckt, wobei die Elektrode eine erste Öffnung in der Form eines vertikalen Streifens mit einer ersten Breite (11) aufweist, der einen Bereich (204) der Ladungsübertragung zwischen dem lichtempfindlichen Bereich (205) und dem Speicher-Bereich (207) definiert; und
wenigstens eine zweite isolierte vertikale Elektrode (209), die sich in dem Substrat zwischen dem Speicher-Bereich (207) und dem Lese-Bereich (211) erstreckt, wobei diese Elektrode eine zweite Öffnung in der Form eines vertikalen Streifens mit einer zweiten Breite (12) aufweist, der einen Bereich (206) der Ladungsübertragung zwischen dem Speicher-Bereich (207) und dem Lese-Bereich (211) definiert,
**dadurch gekennzeichnet, dass** der lichtempfindliche Bereich (205) ein erstes Dotierniveau (N1) besitzt, und der Speicher-Bereich (207) ein zweites Dotierniveau (N2) besitzt, das größer ist als das erste Niveau und dass die zweite Breite (12) kleiner ist als die erste Breite (11).

2. Sensor nach Anspruch 1, wobei:
das Substrat (201) mit einem ersten Leitfähigkeitstyp dotiert ist;
der lichtempfindliche Bereich (205) und der Speicher-Bereich (207) mit einem zweiten Leitfähigkeitstyp dotiert sind; und
eine Schicht (213) mit dem ersten Leitfähigkeitstyp dotiert ist, wobei er ein Dotierniveau besitzt, das größer ist als das des Substrats, und die Oberfläche der lichtempfindlichen (205) und Speicher-(207) Bereiche abdeckt.

3. Sensor nach Anspruch 1 oder 2, wobei der lichtempfindliche Bereich (205) teilweise begrenzt ist durch wenigstens eine dritte isolierte vertikale Elektrode (202; 404), die sich in das Substrat erstreckt.

4. Sensor nach einem der Ansprüche 1 bis 3, der ferner einen Ladungsablauf-Bereich aufweist (402), der neben dem lichtempfindlichen Bereich (205) liegt.

5. Sensor nach Anspruch 4, wobei sich wenigstens eine vierte isolierte vertikale Elektrode (406) in dem Substrat zwischen dem lichtempfindlichen Bereich (205) und dem Ladungsablauf-Bereich (402) erstreckt.

6. Sensor nach Anspruch 5, wobei die wenigstens eine vierte Elektrode (406) wenigstens eine Öffnung aufweist, die einen Bereich (408) der Ladungsübertragung zwischen dem lichtempfindlichen Bereich (205) und dem Ladungsablauf-Bereich (402) definiert.

7. Sensor nach einem der Ansprüche 4 bis 6, wobei der Ladungsablauf-Bereich (402) verbunden ist mit einem Hochleistungsversorgungspfad (V_{DD}) des Sensors.

8. Sensor nach einem der Ansprüche 1 bis 7, der ferner eine Steuerschaltung aufweist, die in der Lage ist, Steuersignale an die vertikalen Elektroden (202, 203, 209; 404, 406) anzulegen.

9. Sensor nach einem der Ansprüche 1 bis 7, wobei der Lese-Bereich (211) gekoppelt ist mit einer Leseschaltung des Sensors.

## Claims

1. An image sensor arranged inside and on top of a semiconductor substrate (201), having a plurality of pixels (200; 400), each comprising:
a photosensitive area (205), a read area (211), and a storage area (207) extending between the photosensitive area (205) and the read area (211);
at least one first insulated vertical electrode (203) extending in the substrate between the photosensitive area (205) and the storage area (207), this electrode comprising a first opening in the form of a vertical strip of a first width (11) defining an area (204) of charge transfer between the photosensitive area (205) and the storage area (207); and
at least one second insulated vertical electrode (209) extending in the substrate between the storage area (207) and the read area (211), this electrode comprising a second opening in the form of a vertical strip of a second width (12) defining an area (206) of charge transfer between the storage area (207) and the read area (211),
**characterized in that** the photosensitive area (205) has a first doping level (N1) and the storage area (207) has a second doping level (N2) greater than the first level and **in that** the second width (12) is lower than the first width (11).

2. The sensor of claim 1, wherein:
the substrate (201) is doped with a first type of conductivity;
the photosensitive area (205) and the storage area (207) are doped with a second type of conductivity; and
a layer (213) doped with the first conductivity type, having a doping level greater than that of the substrate, covers the surface of the photosensitive (205) and storage (207) areas.

3. The sensor of claim 1 or 2, wherein the photosensitive area (205) is partially delimited by at least one third insulated vertical electrode (202; 404) extending in the substrate.

4. The sensor of any of claims 1 to 3, further comprising a charge drain-off area (402) juxtaposed to the photosensitive area (205).

5. The sensor of claim 4, wherein at least one fourth insulated vertical electrode (406) extends in the substrate between the photosensitive area (205) and the charge drain-off area (402).

6. The sensor of claim 5, wherein said at least one fourth electrode (406) comprises at least one opening defining an area (408) of charge transfer between the photosensitive area (205) and the charge drain-off area (402).

7. The sensor of any of claims 4 to 6, wherein said charge drain-off area (402) is connected to a high power supply rail (V_{DD}) of the sensor.

8. The sensor of any of claims 1 to 7, further comprising a control circuit capable of applying control signals to said vertical electrodes (202, 203, 209; 404, 406).

9. The sensor of any of claims 1 to 7, wherein said read area (211) is coupled to a read circuit of the sensor.
